# EUROPEAN PATENT APPLICATION

(11) **EP 0 596 743 A1**
(43) Date of publication of application: **11.05.1994**
(21) Application number: 93308835.3
(22) Date of filing: 04.11.1993
(51) Int. Cl.: G06F 11/22, G01R 13/32

(54) **Programmable HDTV format trigger**

(30) Priority: 04.11.1992 US 971486
(71) Applicant: TEKTRONIX, INC., Wilsonville, Oregon 97070-1000 (US)
(72) Inventor: Proebstel, James B., Beaverton, Oregon 97005 (US)
(74) Representative: Burke, Steven David

(57) **Abstract**

A method of generating a programmable HDTV format trigger signal for an oscilloscope, the trigger signal corresponding to the vertical sync pulse of an input video signal, uses a serial word trigger circuit. Parameters defining the format of the input video signal are input to a lookup table. From these input parameters various vertical sync values are computed. The vertical sync values are then used to generate criteria for the serial word trigger circuit so that it outputs the trigger signal when the input video signal satisfies the criteria.

## Description

### Background of the Invention

The present invention relates to oscilloscope trigger circuits, and more particularly to a programmable High Definition TeleVision (HDTV) format trigger that is adjustable to different HDTV formats and uses a serial word trigger circuit.

In the current television environment there are many proposed HDTV formats, both in the United States and in Japan and Europe. One tool that is used to examine television signals is an oscilloscope. To provide a useful display the oscilloscope needs to trigger on a known point within the television signal. Preferably an acquisition trigger is generated by a vertical sync pulse within the television signal from which appropriate delays may be derived to provide a display of a desired video line or pixel within a line. However the identification of the vertical sync pulse is complicated by the fact that the format for such sync pulse is different for each different television format. For example standard NTSC and PAL video signals have horizontal sync pulses that extend in one direction from a blanking level and have equalizing pulses similar to the horizontal sync pulse to identify the vertical interval. On the other hand the HDTV formats may have bi-polar horizontal sync pulses with one or two additional pulses between horizontal sync pulses to identify the vertical interval. If a manual attempt is made to sync to the vertical interval by setting the trigger level at the midpoint between the blanking level and sync tip, the oscilloscope would trigger on any line. Since the vertical interval is a definite pattern, what is needed to identify the vertical interval is a serial word trigger.

Such a serial word trigger is disclosed in U.S. Patent No. 5,214,784 issued May 25, 1993 to Benjamin Ward and Michael Seckora entitled "Sequence of Events Detector for Serial Digital Data Which Selectively Outputs Match Signal in the Series Which Defines Detected Sequence." The pattern detection technique used requires an incoming signal to satisfy a specified sequence of criteria in order to be recognized as a desired pattern. Each set of criteria in the sequence has a window of time when the signal is either in a specified state or changes from one specified state to another. As each window is satisfied, the next window in the sequence is opened until the last window in the sequence is satisfied, at which point a detect trigger results. If the criteria of one of the windows is violated, the next window is not opened and the sequence starts anew.

What is desired is a method of providing a programmable HDTV format trigger so that a trigger is generated for the vertical sync pulse of a television signal regardless of the format.

### Summary of the Invention

Accordingly the present invention provides a programmable HDTV format trigger for an oscilloscope by building a lookup table of parameters that are input by an operator for a television signal being acquired having a particular HDTV format. The lookup table is then accessed to generate the criteria for a serial word trigger generator. The serial word trigger generator produces an acquisition trigger corresponding to the vertical sync pulse for the particular HDTV format being acquired. The acquisition trigger is then used to produce a display on the oscilloscope of a desired portion of the television signal.

The objects, advantages and other novel features of the present invention are apparent from the following detailed description when read in conjunction with the appended claims and attached drawing.

### Brief Description of the Drawing

Fig. 1 is a block diagram of an oscilloscope trigger circuit according to the present invention.

Fig. 2 is an illustrative view of a pair of HDTV vertical interval formats.

Fig. 3 is an illustrative view of the pair of HDTV vertical interval formats of Fig. 2 clipped to provide only the negative pulses.

Fig. 4 is a flow chart for generating an acquisition trigger from a programmable HDTV format according to the present invention.

### Description of the Preferred Embodiment

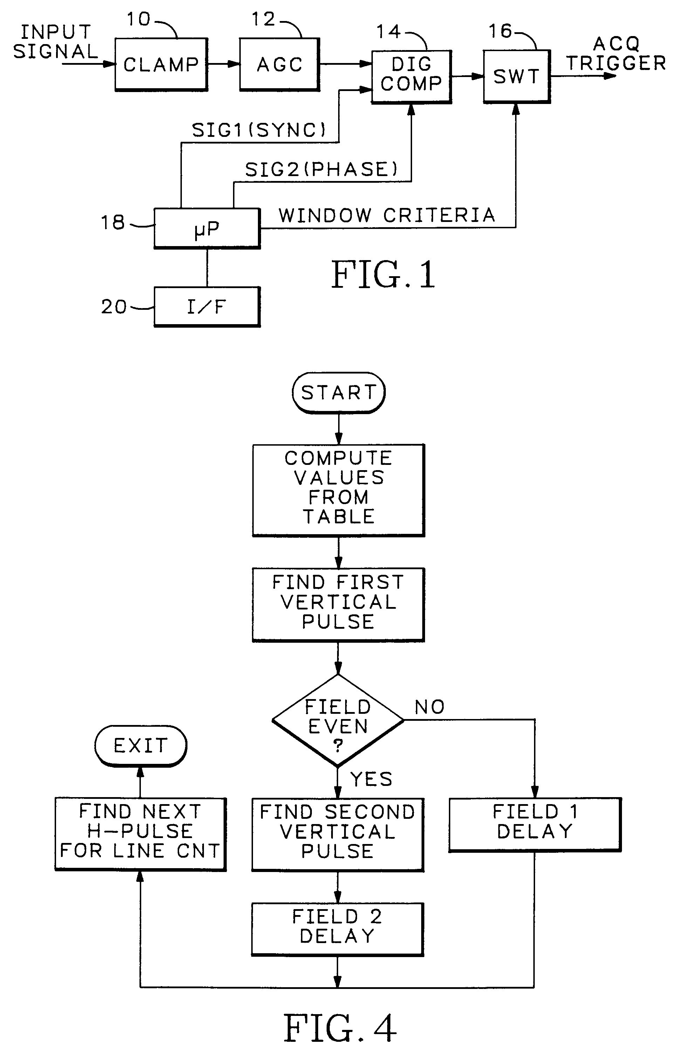

Referring now to Fig. 1 an input signal, in the form of a television signal having one of a defined plurality of formats, is input to a clamp circuit **10**. The clamp circuit **10** clamps a negative sync tip of the television signal to a specified d.c. voltage, such as ground. The clamped television signal from the clamp circuit **10** is input to an Automatic Gain Circuit (AGC) **12** where the blanking level of the television signal is set at a second specified d.c. voltage, such as 300 mV. The output of the AGC **12** is input to a digital comparator circuit **14** where the television signal is compared and digitized with respect to one or more reference levels **SIG1, SIG2.** The resulting pre-conditioned digitized television signal is input to a Serial Word Trigger (SWT) circuit **16** where it is compared with specified criteria as discussed above with respect to the Ward et al patent. When a vertical sync pulse is detected by the SWT **16,** an acquisition trigger is output. Using appropriate delays from the acquisition trigger any particular line of the television signal may be specified with certitude. A microprocessor **18** provides the appropriate level signals **SIG1, SIG2** to the digitizing comparator circuit **14** via appropriate digital to analog (D/A) converters (not shown), as well as loads the appropriate window criteria into the SWT **16,** as specified by an operator via a user interface **20.**

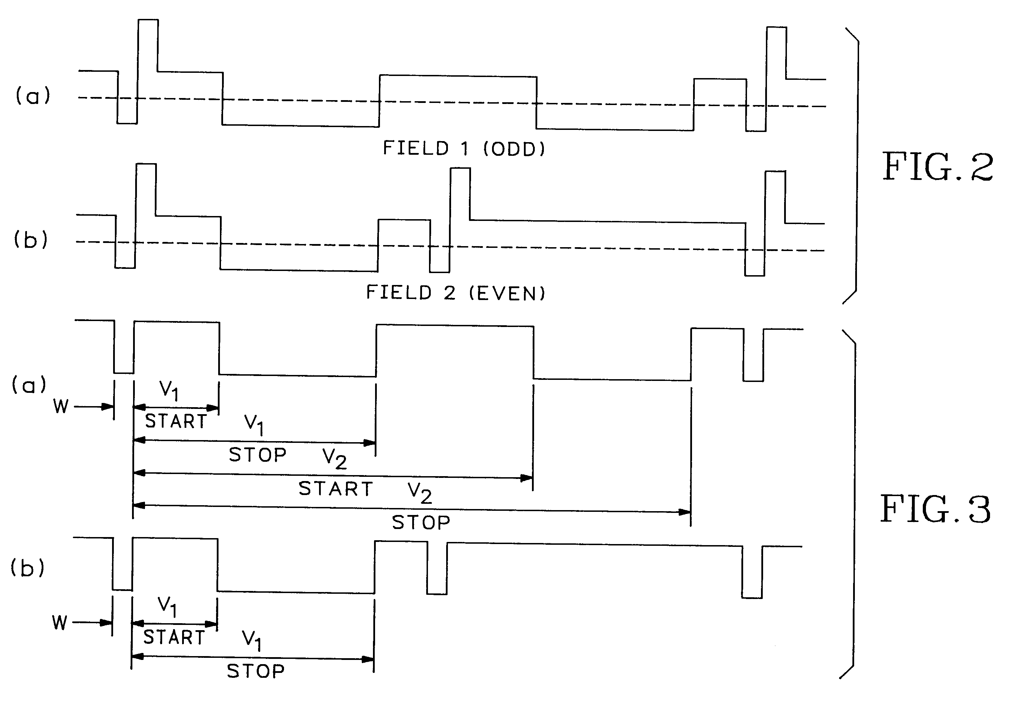

As shown in Fig. 2 one type of HDTV vertical sync pulse format is identified by a bi-polar horizontal sync pulse, followed by two vertical sync pulses before the horizontal sync pulse for the next line of the television signal occurs. Another type of HDTV vertical sync pulse format has the bi-polar horizontal sync pulse followed by a single vertical sync pulse and a half-line horizontal sync pulse. At the output of the digitizing comparator circuit **14** the formats shown in Fig. 2 are clipped as shown in Fig. 3 to provide only the negative pulses to the SWT circuit **16.**

An operator who desires to observe a television signal of a particular HDTV format enters via the user interface **20,** such as an oscilloscope front panel, specific parameters that define the particular HDTV format. These parameters are stored in a table in the microprocessor **18.** These parameters include information such as the frame rate, the maximum number of fields per frame, the maximum number of lines per frame, the pulse width **W** of the negative portion of the horizontal sync pulse, the time **V1**_{**start**} from the positive edge of the horizontal sync pulse to the first negative edge of the television signal (leading edge of a first vertical sync pulse), the time **V1**_{**stop**} from the positive edge of the horizontal sync pulse to the next positive edge of the television signal, the time **V2**_{**start**} from the positive edge of the horizontal sync pulse to the second negative edge of the television signal (leading edge of a second vertical sync pulse), and the time **V2**_{**stop**} from the positive edge of the horizontal sync pulse to the second positive edge of the television signal. From these parameters the microprocessor **18** generates the parameters that define the window criteria for the SWT circuit **16.**

An example is shown in Fig. 4 where initially specific values are calculated from the data in the table. A first pulse width **pw1** is determined from the two **V1** values, a delay value **dly** is determined from the stop **V1** and start **V2** values, a time between horizontal sync points **scan** is determined, and delays **Fld1dly, Fld2dly** are determined from the end of the last vertical pulse in the line for the particular field to the next horizontal sync pulse that indicates the start of the next line of the television signal. From these specific values a negative pulse is searched for after a positive going edge, such as the positive going edge of the horizontal sync pulse. When the negative pulse is detected, a positive edge is searched for at a time starting at 95% of **pw1,** and the search continues for a time equal to 10% of **pw1.** If there are two vertical identifying pulses, such as in field 1, then a positive to negative transition is searched for from 95% of **dly** for a duration of 10% of **dly**. If there are two vertical identification pulses, then one delay value **Fld1dly** is used from the end of the second vertical pulse to the next positive edge indicating the next horizontal sync pulse. If there is only one vertical identification pulse, then the other delay value **Fld2dly** is used from the end of the first vertical pulse to the next positive edge indicating the next horizontal sync pulse. If all of these criteria are met, the acquisition trigger is generated from the SWT circuit **16.** The microprocessor **18** then determines from **scan** when the next horizontal sync pulse occurs to institute a line counting routine.

Although the present invention is described in conjunction with identifying HDTV vertical identifying pulses, the same process may be used for identifying conventional television signal format vertical syncs, such as for NTSC and PAL. In this embodiment the second signal **SIG2** to the digitizing comparator **14** is used to determine the phase of the burst pulse a specified time after the horizontal sync pulse, i.e., the direction of the edge at that specified time determines the phase of the burst pulse relative to the horizontal sync. The phase is used to detect field 1 from field 3 in odd fields, and field 2 from field 4 in even fields.

Thus the present invention provides a means for adapting an oscilloscope to trigger on the vertical sync of any identified television format, such as HDTV formats, by providing for operator input to complete a parameter table, and then determining window criteria for a serial word trigger circuit from the parameters in the table.

## Claims

1. A method of generating a trigger signal, corresponding to a vertical sync pulse of an input video signal having a specified format, for an oscilloscope using a serial word trigger circuit, comprising the steps of:
inputting specified parameters of the specified format into a lookup table;
computing from the specified parameters in the lookup table vertical sync values; and
generating from the vertical sync values criteria for the serial word trigger circuit so that the serial word trigger circuit outputs the trigger signal when the input video signal satisfies the criteria.
